**Europäisches Patentamt**

**European Patent Office**

**Office européen des brevets**

(19)

(11) Veröffentlichungsnummer: **0 195 322 B1**

# EUROPÄISCHE PATENTSCHRIFT

(12)

(45) Veröffentlichungstag der Patentschrift: **30.10.91**

(51) Int. Cl.⁵: **G03F 7/16, G03F 7/30**

(21) Anmeldenummer: **86102976.7**

(22) Anmeldetag: **06.03.86**

(54) Verfahren zur Herstellung eines photopolymerisierbaren Aufzeichnungsmaterials.

(30) Priorität: **21.03.85 DE 3510219**

(43) Veröffentlichungstag der Anmeldung:
**24.09.86 Patentblatt 86/39**

(45) Bekanntmachung des Hinweises auf die
Patenterteilung:
**30.10.91 Patentblatt 91/44**

(84) Benannte Vertragsstaaten:
**DE FR GB**

(56) Entgegenhaltungen:
EP-A- 0 146 505
FR-A- 2 199 135
US-A- 3 085 897
US-A- 3 168 404

(73) Patentinhaber: **HOECHST AKTIENGESELL-
SCHAFT**
**Postfach 80 03 20**
**W-6230 Frankfurt am Main 80(DE)**

(72) Erfinder: **Hilger, Manfred**
**Langenbergring 74**
**W-5503 Konz(DE)**

## Beschreibung

Die Erfindung betrifft ein Verfahren zur Herstellung eines photopolymerisierbaren Aufzeichnungsmaterials, insbesondere eines Trockenphotoresistmaterials mit einem Schichtträger und einer festen, trockenen photopolymerisierbaren Schicht, die als wesentliche Bestandteile

a) ein polymeres, wasserunlösliches, in wäßrigalkalischen Lösungen lösliches Bindemittel,

b) einen radikalisch polymerisierbaren Acryl- oder Methacrylsäureester eines mehrwertigen Alkohols und

c) einen Initiator für die photoinitiierte radikalische Polymerisation

enthält. Die freie Oberfläche der photopolymerisierbaren Schicht wird bevorzugt mit einer dünnen Polyethylenfolie abgedeckt.

Materialien der genannten Gattung sind z. B. aus der US-A 3 469 982 bekannt und werden in großem Umfang zur Herstellung von gedruckten Schaltungen und für ähnliche Anwendungen eingesetzt.

Die Photoresistschicht dieser Materialien muß sich zur trockenen Übertragung auf ein anderes Trägermaterial, z. B. eine Kupferplatte, unter Druck und zumeist unter Erwärmen eignen. Das bedeutet, daß die Schicht zumindest thermoplastisch, vorteilhaft auch bei Normaltemperatur schon plastisch verformbar sein muß und eine gewisse Klebrigkeit haben soll. Materialien, die diese Verarbeitungseigenschaften in optimalem Maße aufweisen, bereiten bei der Lagerung und beim Transport in unbelichtetem Zustand gewisse Probleme. Diese Schichten neigen stets zu einem gewissen kalten Fluß, der sich dadurch bemerkbar macht, daß die Schicht beim Lagern in der Rolle an deren Stirnseiten zwischen den Folien herausquillt und die Wickellagen miteinander verklebt. Man hat dieses Problem dadurch zu lösen versucht, daß man die Schichtzusammensetzung, insbesondere die Natur des thermoplastischen Bindemittels so geändert hat, daß die Fließtemperatur der Schicht heraufgesetzt wird. Dieser Lösung, die z. B. in der DE-A 23 63 806 beschrieben ist, sind deshalb Grenzen gesetzt, weil mit dem Anstieg der Fließtemperatur der unbelichteten Schicht die Sprödigkeit der lichtvernetzten Schicht zunimmt, so daß sich das belichtete Material schlechter verarbeiten läßt.

Eine andere Lösung des Problems wird in der DE-C 23 45 120 beschrieben. Dabei werden die Ränder der Photoresistschicht lichtgehärtet, so daß sie nicht mehr ausfließen kann. Ein Nachteil dieses Verfahrens ist es, daß bei der Verarbeitung des entsprechenden Materials an den Randstreifen Verluste an lichtempfindlicher Substanz entstehen, denn um mit Sicherheit alle anpolymerisierten Anteile der Schicht bei der späteren Kopie auszuschließen, muß ein gewisser Sicherheitsabstand gewählt werden.

In der älteren Europäischen Patentanmeldung EP-A 0 185 155 ist zur Lösung dieses Problems vorgeschlagen worden, die Stirnseiten der Trockenresistrollen mit aufgeklebten Abdeckscheiben abzudecken und so das Herausquellen der photopolymerisierbaren Schichten während der Lagerung zu verhindern.

In der US-A 3 168 404 wird die Behandlung der Oberfläche photopolymerisierbarer Schichten mit einer wäßrigen Lösung eines starken Oxydationsmittels beschrieben, um die bildmäßige Photopolymerisation zu verbessern.

In der US-A 3 085 897 wird die Behandlung von photographischen Beschichtungsemulsionen mit Ammoniak beschrieben, um die Viskosität der Beschichtungslösung beim Trocknungsvorgang zu erhöhen.

Aufgabe der Erfindung war es, ein Verfahren zur Herstellung eines photopolymerisierbaren Aufzeichnungsmaterials der vorstehend angegebenen Art vorzuschlagen, das eine wirksame Verhinderung des kalten Flusses ermöglicht, ohne wesentliche Veränderungen in der Zusammensetzung der Schichtbestandteile vorzunehmen, und das ohne einen zusätzlichen Vorbelichtungsschritt auskommt.

Erfindungsgemäß wird ein Verfahren zur Herstellung eines photopolymerisierbaren Aufzeichnungsmaterials mit einem Schichtträger und einer festen, trockenen photopolymerisierbaren Schicht vorgeschlagen, die als wesentliche Bestandteile

a) ein polymeres, wasserunlösliches, in wäßrigalkalischen Lösungen lösliches Bindemittel,

b) einen radikalisch polymerisierbaren Acryl- oder Methacrylsäureester eines mehrwertigen Alkohols und

c) einen Initiator für die photoinitiierte radikalische Polymerisation

enthält.

Das erfindungsgemäße Verfahren ist dadurch gekennzeichnet, daß man die ganze photopolymerisierbare Schicht mit Ammoniak oder die Ränder der photopolymerisierbaren Schicht mit einem Oxydationsmittel oder mit Ammoniak behandelt.

Die Behandlung mit Ammoniak kann erfolgen, indem der Beschichtungslösung eine Ammoniaklösung in Wasser oder organischem Lösungsmittel zugesetzt und homogen damit vermischt wird. Die Menge des Ammoniaks sollte vorteilhaft so bemessen werden, daß sie etwa 10 bis 100 %, vorzugsweise 15 bis 60 % der zur Neutralisierung der in dem photopolymerisierbaren Gemisch enthaltenen Säuregruppen - zumeist der Carboxylgruppen des Bindemittels - erforderlichen stöchiometrischen Menge entspricht. Die Umsetzung gibt sich durch eine starke Zunahme der Viskosität der Beschichtungslösung zu erkennen.

Die Behandlung mit NH₃ kann auch nach der Beschichtung und dem Aufwickeln der fertigen Trockenresistfolie erfolgen. Hierbei werden in einfacher Weise die Stirnseiten des Wickels mit Ammoniaklösung benetzt, z. B. durch Überwischen mit einem mit der Lösung getränkten Schwamm oder Lappen und Trocknen. Hierbei werden nur die Randbereiche der photopolymerisierbaren Schicht umgesetzt. Dies hat aber im Gegensatz zu der bekannten Lichthärtung keinen Einfluß auf die Lichtempfindlichkeit und Entwickelbarkeit der Randbereiche. Diese werden lediglich in ihrem Fließvermögen stark gehemmt. Die Ammoniakbehandlung hat insgesamt sogar eine gewisse Erhöhung der Lichtempfindlichkeit und eine Verbesserung der Bilddifferenzierung bei der üblichen Verarbeitung zur Folge.

Wenn die Behandlung mit einem Oxydationsmittel erfolgt, wird sie so durchgeführt, daß nur die Ränder bzw. die Stirnseiten des Wickels behandelt werden. Das Oxydationsmittel wird ebenfalls als wäßrige oder organische, bevorzugt als wäßrige Lösung, angetragen. Als Oxydationsmittel kommen z. B. Kaliumpermanganat, Natriumperoxid, Wasserstoffperoxid oder Ammoniumdichromat in Betracht. Die Konzentration und Menge der angewandten Lösung läßt sich in jedem Fall durch einfache Versuche ermitteln. Gegebenenfalls kann nach dem Befeuchten der Stirnseiten mit der Lösung kurze Zeit, z. B. mit Infrarotstrahlung, erwärmt werden, um die Trocknung zu beschleunigen und die Diffusion und Wirkung des Oxydationsmittels zu fördern.

Die Trockenphotoresistmaterialien, die nach dem erfindungsgemäßen Verfahren behandelt werden, sind bekannt und z. B. in den DE-A 20 64 079, 23 63 806, 21 23 702, 28 22 190 und 31 34 123 beschrieben. Sie bestehen im allgemeinen aus einer maßbeständigen Trägerfolie, einer photopolymerisierbaren Schicht und einer Deckfolie. Die Trägerfolie besteht z. B. aus Polyester und hat vorzugsweise eine Stärke im Bereich von 15 bis 30 µm, die Deckfolie eine Stärke von 5 bis 25 µm. Die photopolymerisierbare Schicht enthält als Hauptbestandteile ein thermoplastisches polymeres Bindemittel, polymerisierbare Verbindungen, die vorzugsweise Acryl- oder Methacrylsäureester mehrwertiger aliphatischer Hydroxyverbindungen sind, und einen Photopolymerisationsinitiator. Weitere übliche Bestandteile können Polymerisationsinhibitoren, Farbstoffe, Pigmente, Weichmacher und Vernetzungsmittel sein. Die Schichtdicke liegt im allgemeinen zwischen 10 und 70, vorzugsweise zwischen 15 und 40 µm.

Die folgenden Beispiele beschreiben bevorzugte Ausführungsformen der Erfindung. Gewichtsteile (Gt) und Volumteile (Vt) stehen im Verhältnis von g zu ccm, Prozentzahlen und Mengenverhältnisse sind in Gewichtseinheiten zu verstehen, wenn nichts anderes angegeben ist.

Beispiel 1

Eine Lösung von

| 9 Gt | eines Terpolymerisats aus n-Hexylmethacrylat, Methacrylsäure und Styrol (60:30:10) mit dem mittleren Molgewicht 35000, |
| 6,4 Gt | eines polymerisierbaren Oligourethans, hergestellt durch Umsetzen von 11 mol 2,2,4-Trimethyl-hexamethylendiisocyanat zuerst mit 10 mol Triethylenglykol und dann mit 2 mol Hydroxyethylmethacrylat und |
| 3,9 Gt | des Esters der 2,6-Dihydroxybenzoesäure mit Diethylenglykolmono-2-ethylhexylether in |
| 45 Gt | Butanon und |
| 4,5 Gt | Wasser |

wird unter kräftigem Rühren innerhalb von 30 Minuten mit

1,4 Vt 16 %iger wäßriger NH₃-Lösung

versetzt. Dabei erhöht sich die Viskosität der Lösung von 30 mm²/s auf 70 bis 80 mm²/s.
Anschließend werden

| 0,35 Gt | 9-Phenylacridin und |
| 0,035 Gt | eines blauen Azofarbstoffs, erhalten durch Kuppeln von 2,4-Dinitro-6-chlor-benzoldiazoniumsalz mit 2-Methoxy-5-acetylamino-N-cyanoethyl-N-hydroxyethyl-anilin |

zugesetzt und unter Rühren aufgelöst. Die Lösung wird auf eine biaxial verstreckte und thermofixierte Polyethylenterephthalatfolie von 25 µm so aufgeschleudert, daß nach dem Trocknen ein Schichtgewicht von 28 g/m² erhalten wird.

Eine Probe der erhaltenen Trockenresistfolie wird in einen auf 50 °C beheizten Trockenschrank gelegt und mit einem 1000-g-Gewicht belastet. Nach 16 Stunden ist unter dem Gewicht praktisch keine Verformung der Schicht zu erkennen. Lediglich eine am Boden des Gewichts reliefartig ausgeformte Typnummer ist als leichter Eindruck in der Resistschicht zu erkennen.

Eine weitere Probe der Photoresistfolie wird in üblicher Weise in einem Laminiergerät unter Druck und Erwärmen auf eine gereinigte kupferkaschierte Phenolharz-Preßstoffplatte laminiert und in einem handelsüblichen Belichtungsgerät unter einem Halbton-Stufenkeil belichtet. Nach der Belichtung wird die Polyesterfolie abgezogen und die Schicht mit einer 0,8 %igen Na₂CO₃-Lösung in einem Sprühentwicklungsgerät entwickelt. Es werden 5 vollvernetzte Keilstufen erhalten.

Zum Vergleich wird eine Trockenresistfolie aus den gleichen Bestandteilen hergestellt, die sich von der vorstehend beschriebenen allein dadurch unterscheidet, daß bei der Herstellung der Beschichtungslösung keine Ammoniaklösung zugesetzt wurde. Die Photoresistschicht zeigt nach 16 Stunden Belastung mit einem 1000-g-Gewicht bei 50 ˚C starke ringförmige Verprägungen am Rand des Gewichts; die Typnummer hat sich vollständig bis zur Trägerfolie durchgedrückt und ist deutlich weiß in der blauen Schicht zu erkennen.

Eine weitere Probe der Vergleichsfolie wird ebenso wie oben beschrieben belichtet und entwikkelt. Es werden 4 vollvernetzte Keilstufen erhalten.

Beispiel 2

Eine Trockenresistfolie wird, wie in Beispiel 1 beschrieben, hergestellt, jedoch wird die Beschichtungslösung nicht mit Ammoniaklösung behandelt. Die Photoresistschicht wird im kontinuierlichen Betrieb nach dem Trocknen durch Laminieren mit einer 12 µm dicken Polyethylenfolie abgedeckt. Es werden zwei Rollen von jeweils 45 cm Breite und 200 m Länge hergestellt. Die eine davon wird an den Stirnseiten mit einem Tampon überwischt, der mit 16 %iger wäßriger Ammoniaklösung getränkt ist, und dann getrocknet. Beide Rollen werden dann 5 Tage bei 45 ˚C im Trockenschrank gelagert. Danach sind die Stirnkanten der erfindungsgemäß behandelten Rolle praktisch unverändert. Es sind keine Schichtbestandteile aus den Stirnseiten ausgewandert. Bei der anderen, unbehandelten Rolle zeigen sich an den Stirnseiten stellenweise erhebliche Mengen ausgequollener Schichtsubstanz, die über die einzelnen Lagen des Wickels übergreifend verlaufen ist und beim Abwickeln in der Laminiervorrichtung sowie beim Abtrennen der Deckfolie von der Photoresistschicht zu Störungen, z. B. zum Einreißen der Photoresistschicht oder zum Haften dieser Schicht an der Deckfolie, führt.

Beispiel 3

Eine Trockenresistfolie wird, wie in Beispiel 2 beschrieben, hergestellt. Diese Rolle wird, wie in Beispiel 2 beschrieben, an den Stirnflächen mit einer Lösung behandelt, in diesem Fall mit einer 1 %igen Kaliumpermanganatlösung. Bei Lagerung in der Wärme wie in Beispiel 2 werden ähnliche Ergebnisse erhalten, d. h. an den mit dem Oxydationsmittel behandelten Stirnseiten wird praktisch kein Ausquellen der Schicht beobachtet.

Patentansprüche

1. Verfahren zur Herstellung eines photopolymerisierbaren Aufzeichnungsmaterials mit einem Schichtträger und einer festen, trockenen photopolymerisierbaren Schicht, die als wesentliche Bestandteile

   a) ein polymeres, wasserunlösliches, in wäßrigalkalischen Lösungen lösliches Bindemittel,
   b) einen radikalisch polymerisierbaren Acryl- oder Methacrylsäureester eines mehrwertigen Alkohols und
   c) einen Initiator für die photoinitiierte radikalische Polymerisation

   enthält, dadurch gekennzeichnet, daß man die ganze photopolymerisierbare Schicht mit Ammoniak oder die Ränder der photopolymerisierbaren Schicht mit einem Oxydationsmittel oder mit Ammoniak behandelt.

2. Verfahren nach Anspruch 1, dadurch gekennzeichnet, daß man das Beschichtungsgemisch vor dem Aufbringen auf den Schichtträger mit wäßriger Ammoniaklösung versetzt.

3. Verfahren nach Anspruch 1, dadurch gekennzeichnet, daß man die Stirnseiten der auf einen Schichtträger aufgebrachten und zu einer Rolle aufgewickelten photopolymerisierbaren Schicht mit einer Lösung eines Oxydationsmittels oder von Ammoniak behandelt.

4. Verfahren nach Anspruch 2, dadurch gekennzeichnet, daß man dem Beschichtungsgemisch 0,1 bis 1,0 mol $NH_3$ je Äquivalent im Beschichtungsgemisch enthaltener Säuregruppen zusetzt.

Claims

1. A process for the production of a photopolymerizable recording material comprised of a layer support and a solid, dry photopolymerizable layer which contains, as the essential constituents

   a) a polymeric binder which is insoluble in water and soluble in aqueous-alkaline solutions,
   b) an acrylic or methacrylic acid ester of a polyhydric alcohol, which is polymerizable by a free-radical process, and
   c) an initiator for the photo-induced, free-radical polymerization,

   said process being characterized in that the whole photopolymerizable layer is treated with ammonia or the edges of the photopolymerizable layer are treated with an oxidizing agent or with ammonia.

2. The process as claimed in claim 1, characterized in that the coating composition is mixed with an aqueous solution of ammonia prior to being coated onto the layer support.

3. The process as claimed in Claim 1, characterized in that the end faces of the photopolymerizable layer, which has been coated onto a layer support and wound up to give a roll, are treated with a solution of ammonia or of an oxidizing agent.

4. The process as claimed in Claim 2, characterized in that 0.1 to 1.0 mole of ammonia are added to the coating composition per one equivalent of acid groups contained in the coating composition.

**Revendications**

1. Procédé de fabrication d'un matériau photopolymérisable d'enregistrement comprenant un support de couche et une couche solide sèche photopolymérisable, qui renferme, comme composants principaux:
   a) un liant polymère insoluble dans l'eau et soluble dans les solutions alcalines aqueuses,
   b) un ester d'acide acrylique ou méthacrylique d'un polyol, polymérisable par voie radicalaire, et
   c) un amorceur de photopolymérisation radicalaire, caractérisé en ce que l'on traite toute la couche photopolymérisable avec de l'ammoniac, ou bien les bords de la couche photopolymérisable avec un agent oxydant ou de l'ammoniac.

2. Procédé selon la revendication 1, caractérisé en ce que l'on ajoute au mélange d'enduction une solution aqueuse d'ammoniac, avant son dépôt sur le support de couche.

3. Procédé selon la revendication 1, caractérisé en ce que l'on traite avec une solution d'un agent oxydant ou d'ammoniac les faces terminales d'une couche photopolymérisable déposée sur un support et enroulée en un rouleau.

4. Procédé selon la revendication 2, caractérisé en ce que l'on ajoute au mélange d'enduction de 0,1 à 1,0 mole de $NH_3$ par équivalent de groupe acide présent dans le mélange d'enduction.